(19) **Europäisches Patentamt**
**European Patent Office**
**Office européen des brevets**

(11) **EP 2 882 605 B1**

(12) **EUROPÄISCHE PATENTSCHRIFT**

(45) Veröffentlichungstag und Bekanntmachung des Hinweises auf die Patenterteilung:
**06.04.2016 Patentblatt 2016/14**

(21) Anmeldenummer: **13732828.2**

(22) Anmeldetag: **21.06.2013**

(51) Int Cl.:
*B60L 3/12* *(2006.01)*          *G01R 31/02* *(2006.01)*
*G01R 31/00* *(2006.01)*          *B60R 16/023* *(2006.01)*

(86) Internationale Anmeldenummer:
**PCT/EP2013/001838**

(87) Internationale Veröffentlichungsnummer:
**WO 2014/023374 (13.02.2014 Gazette 2014/07)**

(54) **DIAGNOSEEINRICHTUNG ZUR ÜBERPRÜFUNG EINER STEUERSIGNALLEITUNG**

DIAGNOSTIC APPARATUS FOR CHECKING A CONTROL SIGNAL LINE

DISPOSITIF DE DIAGNOSTIC POUR LA VÉRIFICATION D'UNE LIGNE DE SIGNAUX DE COMMANDE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.08.2012 DE 102012015911**

(43) Veröffentlichungstag der Anmeldung:
**17.06.2015 Patentblatt 2015/25**

(73) Patentinhaber: **Audi AG**
**85045 Ingolstadt (DE)**

(72) Erfinder:
• **ZAKI, Sami**
**93326 Abensberg (DE)**
• **SCHALLI, Niklas**
**81825 München (DE)**
• **STEINLECHNER, Florian**
**92339 Beilngries (DE)**

(74) Vertreter: **Herbst, Matthias Heinz**
**Audi AG**
**Patentabteilung**
**I/EZ-14**
**85045 Ingolstadt (DE)**

(56) Entgegenhaltungen:
**DE-A1- 10 002 537      DE-A1-102004 041 008**
**US-A1- 2010 327 878      US-A1- 2012 146 656**

**Beschreibung**

Die Erfindung betrifft eine Diagnoseeinrichtung zur Überprüfung einer Steuersignalleitung zwischen einem Steuergerät eines Kraftfahrzeugs und einem kraftfahrzeugseitigen Ladeanschluss für eine Batterie des Kraftfahrzeugs. Daneben betrifft die Erfindung ein Kraftfahrzeug sowie ein Verfahren zur Detektion eines Steuersignalleitungsdefekts einer Steuersignalleitung.

Kraftfahrzeuge mit einem Elektromotor sind im Stand der Technik bereits weitgehend bekannt, insbesondere als Elektrokraftfahrzeuge oder, falls sie zusätzlich einen Verbrennungsmotor aufweisen, als Hybridfahrzeuge. Zum Betrieb des Elektromotors des Kraftfahrzeugs ist eine Batterie, meist eine Hochspannungsbatterie, in dem Kraftfahrzeug vorgesehen, welche über geeignete kraftfahrzeugexterne Ladeeinrichtungen (Ladestationen) aufgeladen werden kann.

Als Teil der Ladeinfrastruktur weisen Kraftfahrzeuge daher üblicherweise einen kraftfahrzeugseitigen Ladeanschluss (Ladedose) auf, in die ein Stecker der Ladeeinrichtung eingesteckt werden kann. Der Ladeanschluss ist dabei über eine ein- oder dreiphasige Leitung entsprechend mit der Batterie verbunden oder verbindbar, um ein Laden der Batterie zu ermöglichen; zusätzlich ist jedoch meist eine Steuersignalleitung ("control pilot", kurz CP) zusätzlich vorhanden, die dem Austausch von Steuersignalen dienen kann. Über die Steuersignalleitung kann zum einen eine Ladebereitschaft des Kraftfahrzeugs der Ladeeinrichtung mitgeteilt werden, zusätzlich oder alternativ ist es jedoch auch möglich, dass über die Steuersignalleitung eine Energielieferbereitschaft der Ladeeinrichtung an das Kraftfahrzeug übermittelt wird. Um Informationen auszutauschen, kann beispielsweise ein pulsweitenmoduliertes Steuersignal verwendet werden.

Kraftfahrzeugseitig wird das Steuersignal in einem Steuergerät, beispielsweise einem Ladesteuergerät und/oder Batteriesteuergerät, ausgewertet und/oder erzeugt, welches eine entsprechende Logik aufweist.

Ist das Steuersignal nicht vorhanden, beispielsweise durch einen Defekt in der Steuersignalleitung zwischen dem Steuergerät und dem Ladeanschluss und/oder einen Defekt im Ladekabel oder ladeeinrichtungsseitig, ist ein Laden meist nicht möglich. Insbesondere ist heutzutage jedoch nicht feststellbar, ob ein Fehler im Kraftfahrzeug selbst vorliegt oder in der Ladeinfrastruktur, konkret beispielsweise dem Ladekabel und/oder der Ladeeinrichtung.

Der Erfindung liegt daher die Aufgabe zugrunde, eine Möglichkeit zur Überprüfung einer kraftfahrzeuginternen Steuersignalleitung zwischen einem Steuergerät des Kraftfahrzeugs und einem kraftfahrzeugseitigen Ladeanschluss anzugeben, die insbesondere einfach realisierbar und unter Aufrechterhaltung von Normen umsetzbar ist.

Zur Lösung dieser Aufgabe ist erfindungsgemäß eine Diagnoseeinrichtung der eingangs genannten Art vorgesehen, welche sich dadurch auszeichnet, dass ein erster Widerstand in dem Steuergerät die Steuersignalleitung zu Masse verbindend und ein zweiter, dem ersten Widerstand parallel geschalteter Widerstand ladeanschlussseitig vorgesehen sind, wobei eine Auswerteeinrichtung des Steuergeräts eine Stromquelle und/oder eine Spannungsquelle zur Einspeisung eines Stroms und/oder einer Spannung außerhalb eines Ladevorgangs aufweist und zur Messung eines einen Steuersignalleitungsdefekt anzeigenden Stroms oder einer einen Steuersignalleitungsdefekt anzeigenden Spannung unter Nutzung des ersten und des zweiten Widerstands ausgebildet ist, und wobei in Reihenschaltung zu dem ersten und dem zweiten Widerstand eine den Stromfluss von Masse zu der Steuersignalleitung sperrende Diode vorgesehen ist.

Erfindungsgemäß wird also erstmals eine Diagnoseeinrichtung vorgeschlagen, die dazu in der Lage ist, die Steuersignalleitung von dem Steuergerät bis hin zum Ladeanschluss (der Ladedose) zu überprüfen, so dass die Diagnosemöglichkeiten im Steuergerät erweitert sind. Besonders vorteilhaft ist es dabei, dass diese Diagnose außerhalb des Ladevorgangs, insbesondere also auch während des Betriebs des Kraftfahrzeugs, insbesondere regelmäßig, erfolgen kann (sogenannte "open load"-Diagnose). Mithin lässt sich jederzeit feststellen, ob ein Defekt der Steuersignalleitung im Kraftfahrzeug selber vorliegt.

Heutzutage ist es bereits bekannt, insbesondere auch in einigen Normierungen vorgesehen, kraftfahrzeugseitig im Steuergerät einen bestimmten Widerstand eines bestimmten Werts zwischen der Steuersignalleitung und der Masseleitung vorzusehen. Dies gilt insbesondere dann, wenn eine Ladebereitschaft der Batterie mitgeteilt werden soll, indem ein dem Widerstand im Steuergerät parallel geschalteter Ladebereitschaftswiderstand über einen Ladebereitschaftsschalter zugeschaltet werden soll. Auch der Ladebereitschaftswiderstand kann einen normierten Wert haben. Gemäß der Normierung IEC 61851 zum Zeitpunkt der Anmeldung der vorliegenden Erfindung kann beispielsweise ein Wert des Widerstands in einem Kraftfahrzeug gemäß dem Stand der Technik 2,74 kΩ betragen, der Wert eines Ladebereitschaftswiderstands 1,3 kΩ oder 270 Ω. Ausgehend von einem solchen Stand der Technik kann die Idee der vorliegenden Erfindung so verstanden werden, dass der bislang genutzte, einzige Widerstand im Steuergerät aufgeteilt wird in zwei Widerstände, erfindungsgemäß den ersten, steuergeräteseitigen Widerstand und den zweiten diesem parallel geschalteten ladeanschlussseitigen Widerstand. Die Werte des ersten und des zweiten Widerstandes können dann wieder so gewählt werden, dass Normen erfüllt werden, beispielsweise durch Verwendung eines doppelt so hohen Widerstandswertes für den ersten und den zweiten Widerstand.

In jedem Fall schlägt die vorliegende Erfindung also vor, eine Kombination von parallel geschalteten Widerständen zu beiden Seiten der Steuersignalleitung innerhalb des Kraftfahrzeugs zu verwenden, nämlich den ersten Widerstand im Steuergerät und dem zweiten Widerstand im Ladeanschluss. Nutzt nun eine Auswerteeinrichtung eine Auswerteschaltung, die unterschiedliche Messwerte liefert, je nachdem, ob der zweite Widerstand verfügbar ist, so lässt sich auf einfache, unkomplizierte Weise, ohne dass gerade ein Ladevorgang vorliegen muss, ein Defekt der Steuersignalleitung detektieren, was erfindungsgemäß sowohl anhand eines Stromflusses wie auch anhand eines Spannungsflusses denkbar ist, weshalb das Steuergerät eine Stromquelle oder eine Spannungsquelle aufweist, die außerhalb eines Ladevorgangs für einen Diagnosevorgang aktiviert werden kann und eine von der "Sichtbarkeit" des zweiten Widerstands abhängige Messspannung bzw. einen entsprechenden Messstrom erzeugt. Dieser kann auf einfache Weise, beispielsweise über die ohnehin in einem Steuergerät vorhandene Logik, ausgewertet werden. Beispielsweise kann ein einen Fehler in der Steuersignalleitung anzeigendes Bit gesetzt werden, es kann ein Eintrag in einem Fehlerspeicher abgelegt werden und/oder eine entsprechende Warnleuchte für den Fahrer kann aktiviert werden.

Es ist ferner vorgesehen, dass die Diagnoseeinrichtung in Reihenschaltung zu dem ersten und dem zweiten Widerstand eine den Stromfluss von Masse zu der Steuersignalleitung sperrende Diode aufweist. Auf diese Weise können Stromflüsse, die die Signalauswertung des Steuersignals und/oder beispielsweise seitens einer Ladeeinrichtung vorgesehene Prüfvorgänge stören könnten, von vorneherein vermieden werden. Insbesondere ist es auf diese Weise möglich, entsprechenden Normierungsanforderungen nachzukommen.

Gerade im Hinblick auf die Einhaltung von Normen kann es auch vorteilhaft sein, wenn der erste und der zweite Widerstand den selben Wert aufweisen. Nachdem der erste und der zweite Widerstand in einer Parallelschaltung vorliegen, kann dann, wenn ein bestimmter Widerstandswert durch eine Norm erforderlich ist, beispielsweise für den ersten Widerstand und den zweiten Widerstand jeweils der doppelte Widerstandswert des Normwerts verwendet werden, so dass aufgrund der Parallelschaltung von außen wieder der Normwert "gesehen" wird.

Der Ladeanschluss kann, wie bereits dargelegt wurde, als Ladedose ausgebildet sein, so dass der zweite Widerstand in der Ladedose angeordnet ist. Dort verbindet er ebenso die Steuersignalleitung mit Masse.

Beide Widerstände können mit einer verbundenen, gemeinsamen Masseleitung verbunden sein. Häufig wird auch eine Masseleitung von dem Ladeanschluss zu dem Steuergerät (und auch zur Batterie) geführt, so dass diese ohnehin vorhandene Masseleitung genutzt werden kann, um über die Widerstände die Steuersignalleitung sowohl ladeanschlussseitig wie auch steuergeräteseitig mit Masse zu verbinden. Jegliche andere Möglichkeit, eine Verbindung mit Masse herzustellen, kann jedoch auch genutzt werden, beispielsweise eine Verbindung mit der Karosserie des Kraftfahrzeugs oder dergleichen.

In einer ersten, besonders bevorzugten Ausführungsform der vorliegenden Erfindung kann vorgesehen sein, dass die Auswerteeinrichtung einen der Spannungsquelle derart nachgeschalteten Messwiderstand aufweist, dass sich gemeinsam mit dem ersten und dem zweiten Widerstand ein Spannungsteiler ergibt. Das bedeutet also, es entsteht eine Reihenschaltung aus dem Messwiderstand und der Parallelschaltung des ersten und des zweiten Widerstands, über welche die Spannungsquelle mit Masse verbunden ist. Dies ist ein klassischer Spannungsteiler. Wird nun die Messspannung zwischen dem Messwiderstand und der Parallelschaltung abgegriffen, ist die Messspannung, wie selbstverständlich bekannt ist, vom Wert des effektiven Widerstands der Parallelschaltung abhängig, letztlich also davon, ob die Steuersignalleitung so intakt ist, dass auch der zweite Widerstand zum Gesamtwiderstand der Parallelschaltung beiträgt. Ist die Steuersignalleitung defekt, wird der zweite Widerstand letztlich durch einen unendlich großen Widerstand ersetzt, so dass in der Parallelschaltung nur der erste Widerstand tatsächlich gesehen wird. Dies resultiert in einer Änderung der Messspannung.

Mithin kann also vorgesehen sein, dass die Auswerteeinrichtung zur Detektion eines Steuersignalleitungsdefekts bei Messung einer nur dem ersten Widerstand entsprechenden Spannung an der Parallelschaltung des ersten und des zweiten Widerstands ausgebildet ist. Dabei kann die ohnehin vorhandene Logik des Steuergeräts, welche in der Lage ist, unterschiedliche, an der Parallelschaltung anliegende Spannungen zu detektieren, genutzt bzw. entsprechend erweitert werden. Beispielsweise ist es denkbar, die Messspannung, also die einen Steuersignalleitungsdefekt anzeigende Spannung, am Eingang eines Analog-Digital-Wandlers abzugreifen, wobei jedoch auch andere Arten von Messeinrichtungen und Messschaltungen, die dem Fachmann grundsätzlich bekannt sind, eingesetzt werden können.

In der Summe wird also in dieser ersten Ausführungsform das Konzept eines Spannungsteilers verwendet, um über die Spannungsquelle an der Parallelschaltung unterschiedliche anliegende Messspannungen zu erzeugen, je nachdem, ob die Steuersignalleitung intakt ist oder nicht.

In einer zweiten, weniger bevorzugten Ausführungsform ist es auch denkbar, eine Auswerteschaltung unter Verwendung des ersten und des zweiten Widerstands zu erzeugen, bei der durch eine Stromquelle ein Strom eingespeist wird, der je nach Erreichbarkeit des zweiten Widerstandes unterschiedliche Werte eines Messstroms zur Folge hat. Dabei kann vorgesehen sein, die Stromquelle zum Anlegen eines vorbestimmten Stroms durch die Parallelschaltung aus dem ersten und dem zweiten Widerstand ausgebildet ist, wobei die Auswerteeinrichtung eine Strommesseinrichtung zur Messung des durch den ersten Widerstand fließenden Stroms umfasst. Auf diese Weise wird die Parallelschaltung also als ein Stromteiler verwendet. Sind beide Widerstandswerte gleich, liegt durch beide Widerstände die Hälfte des Stroms vor. Ist die Steuersignalleitung defekt, kann also durch den zweiten Widerstand kein Strom fließen, fließt der gesamte Strom über den ersten Widerstand. Der Strom durch den ersten Widerstand kann daher als Messstrom gemessen werden, nachdem er anzeigt, wann ein Steuersignalleitungsdefekt vorliegt. Für diese Ausführungsform ist allerdings eine Strommesseinrichtung notwendig, so dass nicht in der Logik ohnehin vorhandene Komponenten genutzt werden können.

In weiterer Ausgestaltung der vorliegenden Erfindung kann die Auswerteeinrichtung ferner ein Schaltmittel zum selektiven Zuschalten der Spannungsquelle und/oder der Stromquelle zur Durchführung eines Diagnosevorgangs außerhalb eines Ladevorgangs umfassen. Auf diese Weise ist es möglich, außerhalb von Ladevorgängen durch Schließen des Schaltmittels Diagnosevorgänge einzuleiten, in denen dann die Messspannung bzw. der Messstrom aufgenommen wird. Solche Diagnosevorgänge können durch das Steuergerät selbst insbesondere zyklisch angestoßen werden oder auch durch weitere Steuergeräte, beispielsweise im Rahmen eines weitergehenden Diagnosevorgangs des Kraftfahrzeugs, angestoßen werden, was ebenso zyklisch erfolgen kann.

Neben der Diagnoseeinrichtung betrifft die vorliegende Erfindung auch ein Kraftfahrzeug, welches eine erfindungsgemäße Diagnoseeinrichtung aufweist. Ein solches Kraftfahrzeug ist aufgrund der erfindungsgemäßen Diagnoseeinrichtung mithin in der Lage, selbst einen Defekt in einer Steuersignalleitung zwischen einem Ladeanschluss und einem Steuergerät zu detektieren. Sämtliche Ausführungen bezüglich der erfindungsgemäßen Diagnoseeinrichtung lassen sich analog auf das erfindungsgemäße Kraftfahrzeug übertragen, so dass auch mit diesem die dort bereits genannten Vorteile erreicht werden können.

Schließlich betrifft die vorliegende Erfindung auch ein Verfahren zur Detektion eines Steuersignalleitungsdefekts einer Steuersignalleitung zwischen einem Steuergerät eines Kraftfahrzeugs und einem kraftfahrzeugseitigen Ladeanschluss für eine Batterie des Kraftfahrzeuges, welches sich dadurch auszeichnet, dass ein erster Widerstand in dem Steuergerät die Steuersignalleitung zu Masse verbindend und ein zweiter, dem ersten Widerstand parallel geschalteter Widerstand ladeanschlussseitig verwendet werden, wobei außerhalb eines Ladevorgangs eine Spannung und/oder ein Strom in eine den ersten und den zweiten Widerstand umfassende Schaltung eingespeist wird und an einer anderen Stelle der Schaltung ein von der Verfügbarkeit des zweiten Widerstandes abhängiger Strom oder eine von der Verfügbarkeit des zweiten Widerstandes abhängige Spannung gemessen und bezüglich des Steuersignalleitungsdefekts ausgewertet wird. Sämtliche Ausführungen zur erfindungsgemäßen Diagnoseeinrichtung lassen sich auch auf das erfindungsgemäße Verfahren übertragen, welches mithin vorteilhafterweise unter Verwendung einer erfindungsgemäßen Diagnoseeinrichtung durchgeführt werden kann. Auch bei dem erfindungsgemäßen Verfahren wird mithin überprüft, ob der zweite Widerstand erreichbar ist, mithin ein Defekt der Steuersignalleitung vorliegt.

Weitere Vorteile und Einzelheiten der vorliegenden Erfindung ergeben sich aus den im Folgenden beschriebenen Ausführungsbeispielen sowie anhand der Zeichnungen. Dabei zeigen:

Fig. 1    eine Prinzipskizze eines erfindungsgemäßen Kraftfahrzeugs, und

Fig. 2    eine die Funktionsweise der erfindungsgemäßen Diagnoseeinrichtung zeigende Zeichnung.

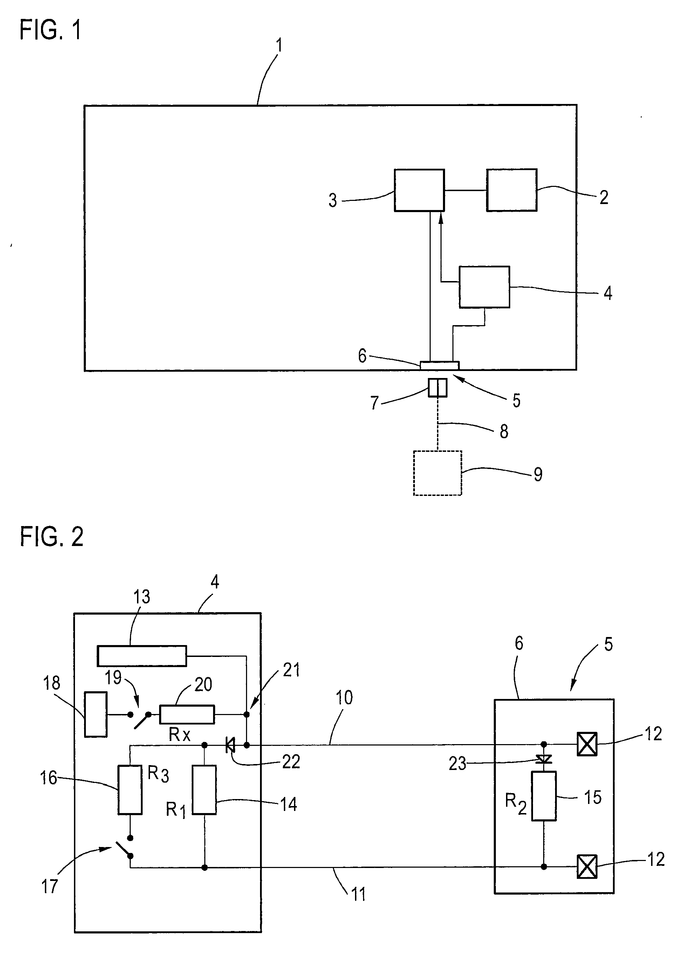

Fig. 1 zeigt eine Prinzipskizze eines erfindungsgemäßen Kraftfahrzeugs 1. Nachdem es sich bei dem Kraftfahrzeug 1 um ein Elektrokraftfahrzeug handelt, weist dieses einen Elektromotor 2 auf, der von einer Batterie 3 (Hochspannungsbatterie) gespeist wird. Der Betrieb der Batterie 3, insbesondere auch ihr Ladebetrieb, wird durch das Batteriesteuergerät 4 gesteuert. Um die Batterie 3 laden zu können, weist das Kraftfahrzeug 1 einen Ladeanschluss 5 in Form einer Ladedose 6 auf, wobei Steuersignale an das Steuergerät 4, Energie jedoch an die Batterie 3 weitergeleitet wird.

Über einen Stecker 7 eines hier nur angedeuteten Ladekabels 8 kann das Kraftfahrzeug 1 mit einer Ladeeinrichtung 9 (Ladestation) verbunden werden, so dass dann ein Ladevorgang durchgeführt werden kann.

Der Ladevorgang wird mitbestimmt durch Steuersignale, die zwischen dem Steuergerät 4 und der Ladeeinrichtung 9 ausgetauscht werden können. Hierzu ist eine spezielle Steuersignalverbindung (control pilot) vorgesehen.

Fig. 2 zeigt die Realisierung innerhalb des Kraftfahrzeugs 1 näher, was die Verbindung zwischen dem Steuergerät 4 und dem Ladeanschluss 5 betrifft.

Der Übersichtlichkeit halber sind Energieversorgungsleitungen und dergleichen nicht dargestellt. Von der Ladedose 6 zum Steuergerät 4 sind eine Steuersignalleitung 10 und eine Masseleitung 11 vorgesehen, die mit entsprechenden Pins 12 verbunden sind. Das Signal der Steuersignalleitung 10 wird ersichtlich an eine Logik 13 des Steuergeräts 4 weitergeleitet, um dort wie im Stand der Technik bereits bekannt ausgewertet zu werden.

Wie im Folgenden nun näher dargestellt werden wird, ist das Steuergerät 4 zur Durchführung des erfindungsgemäßen Verfahrens ausgebildet; hierzu sind im Ladeanschluss 5 und dem Steuergerät 4 jeweils Bestandteile einer erfindungsgemäßen Diagnoseeinrichtung realisiert.

Über einen ersten Widerstand 14 ist die Steuersignalleitung 10 im Steuergerät 4 mit der Masseleitung 11 verbunden. Parallel geschaltet zu dem ersten Widerstand 14 ist in der Ladedose 6 ein zweiter Widerstand 15 vorgesehen, der ebenso die Steuersignalleitung 10 mit der Masseleitung 11 verbindet. Der Wert $R_1$ des ersten Widerstands 14 entspricht hier dem Wert $R_2$ des zweiten Widerstands 15, so dass in der Summe die Parallelschaltung aus dem ersten Widerstand 14 und dem zweiten Widerstand 15 wie ein einziger Widerstand des halben Werts von $R_1$ bzw. $R_2$ wirkt. Vorliegend ist $R_1$ = $R_2$ = 5,48 kΩ gewählt, so dass effektiv durch die Parallelschaltung ein Widerstand von 2,74 kΩ vorliegt, um eine Norm zu erfüllen, die sich auf einen Ladebereitschaftswiderstand 16 mit dem Wert $R_3$ = 1,3 kΩ bezieht. Dem Ladebereitschaftswiderstand 16 ist ein Ladebereitschaftsschalter 17 zugeordnet, der geschlossen wird, wenn eine Ladebereitschaft der Batterie 3 angezeigt werden soll, so dass in diesem Fall eine Widerstandsänderung seitens einer Ladeeinrichtung detektiert werden kann.

Nachdem der erfindungsgemäß vorgesehene Diagnosevorgang jedoch außerhalb des Ladevorgangs stattfindet, ist der Ladebereitschaftsschalter 17 ohnehin geöffnet, so dass mithin nur die parallel geschalteten Widerstände 14 und 15 relevant sind. Nachdem der zweite Widerstand 15 ladeanschlussseitig vorgesehen ist, wird eine Diagnose der Steuersignalleitung 10 unter Verwendung einer Auswerteeinrichtung ermöglicht, wie im Folgenden näher dargelegt werden soll.

Als Teil der Auswerteeinrichtung ist innerhalb des Steuergeräts 4 eine Spannungsquelle 18 vorgesehen. Wird ein Schaltmittel 19 zur Einleitung des Diagnosevorgangs geschlossen, ist die Spannungsquelle 18 über einen Messwiderstand 20 mit dem Wert $R_x$ an die Parallelschaltung aus den Widerständen 14 und 15 angekoppelt, das bedeutet, bezüglich der Spannungsquelle sind der Messwiderstand 20 und die Parallelschaltung der Widerstände 14 und 15 in Reihe geschaltet, so dass sich ein Spannungsteiler ergibt, das bedeutet, die am Punkt 21 abgegriffene Messspannung ist abhängig vom Widerstandswert der Parallelschaltung aus den Widerständen 14 und 15.

Über die Logik 13, gegebenenfalls entsprechend erweitert, kann der Wert der Messspannung 21 während des Diagnosevorgangs, der ja außerhalb des Ladevorgangs stattfindet, gemessen werden, wobei der gemessene Spannungswert von der Erreichbarkeit des zweiten Widerstands 15, mithin der Intaktheit der Steuersignalleitung 10, abhängig ist.

Ist die Steuersignalleitung 10 intakt, bedeutet dies, dass die Parallelschaltung den effektiven Widerstand der beiden parallel geschalteten Widerstände 14 und 15 aufweist, mithin

$$R_p = \frac{R_1 \cdot R_2}{R_1 + R_2} = \frac{R_1}{2},$$

wie oben bereits erläutert wurde. Ist jedoch die Steuersignalleitung 10 defekt, wird statt des zweiten Widerstands 15 ein unendlich großer Widerstand angenommen, so dass effektiv in der Parallelschaltung nur $R_1$ des ersten Widerstands 14 wahrnehmbar ist. Es ergeben sich mithin unterschiedliche Spannungen, von denen eine einem Defekt der Steuersignalleitung 10 zugeordnet werden kann.

Eine entsprechende Detektion der Messspannung kann, wie bereits dargelegt wurde, über die Logik 13, die ohnehin die insbesondere pulsweit moduliert übertragenen Steuersignale auswertet, leicht gemessen werden, beispielsweise am Eingang eines Analog-Digital-Wandlers oder einer anderweitigen Spannungsmesseinrichtung. Abhängig vom Wert der Messspannung, mithin der Information, ob ein Steuersignalleitungsdefekt vorliegt oder nicht, kann ein Fehlerbit gesetzt werden, ein Eintrag in einem Fehlerspeicher abgelegt werden und/oder eine Warnleuchte für den Fahrer angesteuert werden. Selbstverständlich sind jedoch auch andere Maßnahmen denkbar. Der hier beschriebene Diagnosevorgang, für dessen Dauer das Schaltmittel 19 geschlossen ist, kann beispielsweise zyklisch durchgeführt werden. Nach Abschluss der Messung wird das Schaltmittel 19 dann wieder geöffnet. Ein Diagnosevorgang findet nicht statt, während gerade ein Ladevorgang vorliegt. Dann ist das Schaltmittel 19 mithin grundsätzlich geöffnet.

In dem in Fig. 2 dargestellten Ausführungsbeispiel der vorliegenden Erfindung wird als Auswerteschaltung mithin ein Spannungsteiler gebildet, der von der Spannungsquelle 18 gespeist wird. In alternativen Ausführungsbeispielen ist es jedoch auch denkbar, eine Stromquelle zu verwenden, die einen entsprechend variablen Ausgangsstrom an einer anderen Stelle der dann modifizierten Auswerteschaltung erzeugt, beispielsweise nach Art eines Stromteilers.

Dem ersten Widerstand 14 respektive der Parallelschaltung der Widerstände 14, 16 ist genau wie dem zweiten Widerstand 15 jeweils eine Diode 22, 23 in Reihe vorgeschaltet, wobei selbstverständlich auch eine Anordnung der Dioden 22, 23 zu Masse 11 hin denkbar ist. Dies vermeidet einen Stromfluss von Masse 11 in Richtung der Steuersignalleitung 10.

**Patentansprüche**

1. Diagnoseeinrichtung zur Überprüfung einer Steuersignalleitung (10) zwischen einem Steuergerät (4) eines Kraftfahrzeugs (1) und einem kraftfahrzeugseitigen Ladeanschluss (5) für eine Batterie (3) des Kraftfahrzeuges (1),
   **dadurch gekennzeichnet,**
   **dass** ein erster Widerstand (14) in dem Steuergerät (4) die Steuersignalleitung (10) zu Masse (11) verbindend und ein zweiter, dem ersten Widerstand (14) parallel geschalteter Widerstand (15) ladeanschlussseitig vorgesehen sind, wobei eine Auswerteeinrichtung des Steuergeräts (4) eine Stromquelle und/oder eine Spannungsquelle (18) zur Einspeisung eines Stroms und/oder einer Spannung außerhalb eines Ladevorgangs aufweist und zur Messung eines einen Steuersignalleitungsdefekt anzeigenden Stroms oder einer einen Steuersignalleitungsdefekt anzeigenden Spannung unter Nutzung des ersten und des zweiten Widerstands (14, 15) ausgebildet ist, und wobei in Reihenschaltung zu dem ersten und dem zweiten Widerstand (14, 15) eine den Stromfluss von Masse (11) zu der Steuersignalleitung (10) sperrende Diode (22, 23) vorgesehen ist.

2. Diagnoseeinrichtung nach Anspruch 1,
   **dadurch gekennzeichnet,**
   **dass** der erste und der zweite Widerstand (14, 15) den selben Wert aufweisen.

3. Diagnoseeinrichtung nach Anspruch 1 oder 2,
   **dadurch gekennzeichnet,**
   **dass** der zweite Widerstand (15) in einer Ladedose (6) angeordnet ist.

4. Diagnoseeinrichtung nach einem der vorangehenden Ansprüche,
   **dadurch gekennzeichnet,**
   **dass** beide Widerstände (14, 15) mit einer verbundenen, gemeinsamen Masseleitung (11) verbunden sind.

5. Diagnoseeinrichtung nach einem der vorangehenden Ansprüche,
   **dadurch gekennzeichnet,**
   **dass** die Auswerteeinrichtung einen der Spannungsquelle (18) derart nachgeschalteten Messwiderstand (20) aufweist, dass sich gemeinsam mit dem ersten und dem zweiten Widerstand (14, 15) ein Spannungsteiler ergibt.

6. Diagnoseeinrichtung nach Anspruch 5,
   **dadurch gekennzeichnet,**
   **dass** die Auswerteeinrichtung zur Detektion eines Steuersignalleitungsdefekts bei Messung einer nur dem ersten Widerstand (14) entsprechenden Spannung an der Parallelschaltung des ersten und des zweiten Widerstands (14, 15) ausgebildet ist.

7. Diagnoseeinrichtung nach einem der vorangehenden Ansprüche,
   **dadurch gekennzeichnet,**
   **dass** die Stromquelle zum Anlegen eines vorbestimmten Stroms durch die Parallelschaltung aus dem ersten und dem zweiten Widerstand ausgebildet ist, wobei die Auswerteeinrichtung eine Strommesseinrichtung zur Messung des durch den ersten Widerstand (14) fließenden Stroms umfasst.

8. Diagnoseeinrichtung nach einem der vorangehenden Ansprüche,
   **dadurch gekennzeichnet,**
   **dass** die Auswerteeinrichtung ferner ein Schaltmittel (19) zum selektiven Zuschalten der Spannungsquelle (18) und/oder der Stromquelle zur Durchführung eines Diagnosevorgangs außerhalb eines Ladevorgangs umfasst.

9. Kraftfahrzeug (1), umfassend eine Diagnoseeinrichtung nach einem der vorangehenden Ansprüche.

10. Verfahren zur Detektion eines Steuersignalleitungsdefekts einer Steuersignalleitung (10) zwischen einem Steuergerät (4) eines Kraftfahrzeugs (1) und einem kraftfahrzeugseitigen Ladeanschluss (5) für eine Batterie (3) des Kraftfahrzeuges (1),
    **dadurch gekennzeichnet,**
    **dass** ein erster Widerstand (14) in dem Steuergerät (4) die Steuersignalleitung (10) zu Masse verbindend und ein zweiter, dem ersten Widerstand (14) parallel geschalteter Widerstand (15) ladeanschlussseitig verwendet werden, wobei in Reihenschaltung zu dem ersten und dem zweiten Widerstand (14, 15) eine den Stromfluss von Masse (11) zu der Steuersignalleitung (10) sperrende Diode (22, 23) vorgesehen ist, wobei außerhalb eines Ladevorgangs eine Spannung und/oder ein Strom in eine den ersten und den zweiten Widerstand (14, 15) umfassende Schaltung eingespeist wird und an einer anderen Stelle der Schaltung ein von der Erreichbarkeit des zweiten Widerstandes (15) abhängiger Strom oder eine von der Erreichbarkeit des zweiten Widerstandes (15) abhängige Spannung gemessen und bezüglich des Steuersignalleitungsdefekts ausgewertet wird.

## Claims

1. Diagnosis device for checking a control signal line (10) between a control device (4) of a motor vehicle (1) and a charging connection (5) on the vehicle side for a battery (3) of the motor vehicle (1),
   **characterised in that**
   a first resistor (14) in the control device (4) connecting the control signal line (10) to earth (11) and a second resistor (15), connected in parallel to the first resistor (14) on the charging connection side are provided, wherein an evaluation unit of the control device (4) has a current source and/or a voltage source (18) for supplying a current and/or a voltage outside the charging process and is designed for measuring a current indicating a control signal line fault or a voltage indicating a control signal line fault using the first and the second resistor (14, 15), and wherein in series connection to the first and the second resistor (14, 15) a diode (22, 23) is provided which blocks the current flow from earth (11) to the control signal line (10).

2. Diagnosis device according to claim 1 **characterised in that** the first and the second resistor (14, 15) have the same value.

3. Diagnosis device according to claim 1 or 2 **characterised in that** the second resistor (15) is arranged in a charging socket (6).

4. Diagnosis device according to any one of the preceding claims **characterised in that** the two resistors (14, 15) are connected by means of a connected, joint earth lead (11).

5. Diagnosis device according to any one of the preceding claims **characterised in that** the evaluation unit has a measuring resistor (20) arranged downstream of the voltage source (18) in such a way that together with the first and the second resistor (14, 15) a voltage divider results.

6. Diagnosis device according to claim 5 **characterised in that** the evaluation unit is designed for the detection of a control signal line fault through measuring a voltage only corresponding to the first resistor (14) on the parallel circuit of the first and the second resistor (14, 15).

7. Diagnosis device according to any one of the preceding claims **characterised in that** the current source is designed for applying a predetermined current through the parallel circuit of the first and the second resistor, wherein the evaluation unit comprises a current flow measuring device for measuring the current flowing through the first resistor (14).

8. Diagnosis device according to any one of the preceding claims **characterised in that** the evaluation unit also comprises switching means (19) for the selective switching on of the voltage source (18) and/or the current course for carrying out a diagnosis procedure outside the charging process.

9. Motor vehicle (1) comprising a diagnosis device according to any one of the preceding claims.

10. Method of detecting a control line fault in a control signal line (10) between a control device (4) of a motor vehicle (1) and charging connection (5) on the vehicle side for a battery (3) of the motor vehicle (1), **characterised in that** a first resistor (14) in the control device (4) connecting the control signal line (10) to earth and a second resistor (15), connected in parallel to the first resistor (14) on the charging connection side are used, wherein in series connection to the first and the second resistor (14, 15) a diode (22, 23) is provided which blocks the current flow from earth (11) to the control signal line (10), wherein outside a charging process a voltage and/or a current is supplied to the circuit containing the first and the second resistor (14, 15) and at another point of the circuit a current dependent on the reachability of the second resistor (15) or a voltage dependant on the reachability of the second resistor (15) is measured and evaluated with regard to the control signal line fault.

**Revendications**

1. Dispositif de diagnostic pour la vérification d'une ligne de signaux de commande (10) entre un appareil de commande (4) d'un véhicule automobile (1) et une borne de recharge (5), côté véhicule automobile, pour une batterie (3) du véhicule automobile (1), **caractérisé en ce qu'**il est prévu une première résistance (14) dans l'appareil de commande (4), reliant la ligne de signaux de commande (10) à la masse (11), et une deuxième résistance (15), branchée en parallèle avec la première résistance (14) et du côté de la borne de recharge, un dispositif d'évaluation de l'appareil de commande (4) comportant une source de courant et/ou une source de tension (18) pour l'alimentation en un courant et/ou une tension en dehors d'une opération de recharge et étant conçu pour la mesure d'un courant indiquant un défaut de ligne de signaux de commande ou une tension indiquant un défaut de ligne de signaux de commande en exploitant la première et la deuxième résistance (14, 15) et une diode (22, 23) qui bloque le flux de courant de la masse (11) à la ligne de signaux de commande (10) étant prévue dans un branchement en série avec la première et la deuxième résistance (14, 15).

2. Dispositif de diagnostic selon la revendication 1, **caractérisé en ce que** la première et la deuxième résistance (14, 15) ont la même valeur.

3. Dispositif de diagnostic selon la revendication 1 ou 2, **caractérisé en ce que** la deuxième résistance (15) est agencée dans une prise de recharge (6).

4. Dispositif de diagnostic selon l'une des revendications précédentes, **caractérisé en ce que** les deux résistances (14, 15) sont reliées à une ligne de masse (11) commune et raccordée.

5. Dispositif de diagnostic selon l'une des revendications précédentes, **caractérisé en ce que** le dispositif d'évaluation comporte une résistance de mesure (20) qui est branchée en aval de la source de tension (18) de telle sorte qu'il en résulte, conjointement avec la première et la deuxième résistance (14, 15), un diviseur de tension.

6. Dispositif de diagnostic selon la revendication 5, **caractérisé en ce que** le dispositif d'évaluation est conçu pour la détection d'un défaut de ligne de signaux de commande grâce à la mesure d'une tension ne correspondant qu'à la première résistance (14) au niveau du circuit parallèle composé de la première et de la deuxième résistance (14, 15).

7. Dispositif de diagnostic selon l'une des revendications précédentes, **caractérisé en ce que** la source de courant est conçue pour appliquer un courant prédéterminé dans le circuit parallèle composé de la première et de la deuxième résistance, le dispositif d'évaluation comprenant un dispositif de mesure de courant pour mesurer le courant passant dans la première résistance (14).

8. Dispositif de diagnostic selon l'une des revendications précédentes, **caractérisé en ce que** le dispositif d'évaluation comprend en plus un moyen de commutation (19) pour brancher sélectivement la source de tension (18) et/ou la source de courant afin d'effectuer une opération de diagnostic en dehors d'une opération de recharge.

9. Véhicule automobile (1), comprenant un dispositif de diagnostic selon l'une des revendications précédentes.

10. Procédé de détection d'un défaut de ligne de signaux de commande d'une ligne de signaux de commande (10) entre un appareil de commande (4) d'un véhicule automobile (1) et une borne de recharge (5) côté véhicule automobile pour une batterie (3) du véhicule automobile (1),
**caractérisé en ce qu'**il est prévu une première résistance (14) dans l'appareil de commande (4), reliant la ligne de signaux de commande (10) à, la masse, et une deuxième résistance (15), branchée en parallèle avec la première résistance (14) et du côté de la borne de recharge, une diode (22, 23) qui bloque le flux de courant de la masse (11) à la ligne de signaux de commande (10) étant prévue dans un branchement en série avec la première et la deuxième résistance (14, 15), une tension et/ou un courant étant introduit en dehors d'une opération de charge dans un circuit qui comprend la première et la deuxième résistance (14, 15) et, à un autre point du circuit, un courant qui dépend de la possibilité d'atteindre la deuxième résistance (15) ou une tension qui dépend de la possibilité d'atteindre la deuxième résistance (15) étant mesuré et évalué pour détecter un défaut de la ligne de signaux de commande.

FIG. 1

FIG. 2